# EUROPEAN PATENT SPECIFICATION

(11) **EP 0 377 937 B1**
(45) Date of publication and mention of the grant of the patent: **27.12.1995**
(21) Application number: 89308199.2
(22) Date of filing: 11.08.1989
(51) Int. Cl.: G06K 19/07

(54) **IC card**
Chipkarte
Carte à puce

(30) Priority: 12.01.1989 JP 5708/89
(43) Date of publication of application: 18.07.1990
(73) Proprietor: MITSUBISHI DENKI KABUSHIKI KAISHA, Tokyo 100 (JP)
(72) Inventor: Kodai, Syojiro c/o Kitaitami Seisakusho of, Itami City Hyogo Prefecture (JP); Ochi, Katsunori c/o Kitaitami Seisakusho of, Itami City Hyogo Prefecture (JP)
(74) Representative: Mounteney, Simon James

(56) References cited:
- EP-A- 0 254 444
- EP-A- 0 277 854
- EP-A- 0 297 991

## Description

### BACKGROUND OF THE INVENTION

### FIELD OF THE INVENTION

The present invention relates to an IC card formed by mounting an IC (Integrated Circuit) on a circuit board and molding them with resin.

### DESCRIPTION OF THE RELATED ART

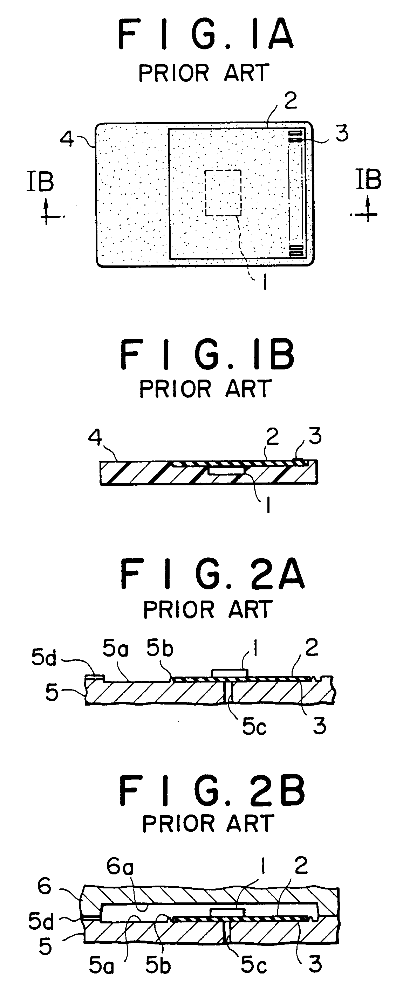

Fig. 1A is a plan view which illustrates a conventional IC card, and Fig. 1B is a cross-sectional view which illustrates the same. An integrated circuit 1 (abbreviated as "IC" hereinafter) is mounted on a reverse side of a circuit board 2 and connected to a circuit (not shown) formed on the same side of this circuit board 2. A plurality of electrode terminals 3 for establishing an electrical connection between the IC 1 and outer equipment is disposed at an end portion of the inverse side of the circuit board 2, that is, the obverse side of the same, these electrode terminals 3 are connected to the above circuit formed on the inverse side of the circuit board 2. Thus-formed circuit board 2 is fitted and bonded, with an adhesive (not shown), within a recessed portion formed in a card base body 4 composed of molding synthetic resin, such as to expose the obverse side of the circuit board. In an another method for assembling of the IC card, as shown in Figs. 2A and 2B, the thus-formed circuit board 2 is molded by sealing with resin as follows: first, the circuit board 2 is, as shown in Fig. 2A, disposed within a recessed portion 5a of the lower mold 5 such that the side on which the electrode terminal 3 is disposed is allowed to face downward and the two ends thereof are respectively supported by a pair of positioning projections 5b. Then, the circuit board 2 is fixed within the recessed portion 5a by reducing pressure through a suction hole 5c. Next, as shown in Fig. 2B, an upper mold 6 is secured to the lower mold 5. Then, molten synthetic resin is introduced through a runner 5d and injected into the recessed portions 5a and 6a. Thus, as shown in Fig. 1, an IC card in which the circuit board 2 is embedded in the card base body 4 as to be integrated with the latter and the obverse side of the circuit substrate 2 is allowed to appear.

In the conventional IC card formed as described above, a problem rises in the type of an IC card formed by adhering the circuit board 2 to which the IC 1 is secured to the reverse side of this circuit board 2 to the recessed portion in the card base body 4 which has been previously molded, the problem being such as a deterioration of the adhesion and water invasion from outside to the adhered portion. On the other hand, an IC card formed by integrally embedding the one side of the circuit board 2 with synthetic resin rises a problem in that the circuit board 2 cannot be readily secured to the mold. In addition, a large portion of one surface of the IC card 1 is covered with the obverse surface of the circuit board 2, which deteriorates the quality in terms of appearance of the IC card. It as well causes a problem in that it is difficult to apply a print or the like to the surface, and causes a limitation in terms of design of the IC card. Another problem rises, due to the fact that the surface of the circuit board 2 is allowed to appear on one surface of the card base body 4, in that the card can be warped due to the difference between the thermal expansion coefficients of the circuit board 2 and the card base body 4. As a result, a bond strength between the circuit board 2 and the body 4 deteriorates.

EP-A-0 254 444 discloses an integrated circuit module in which the circuit board is completely encapsulated on both sides, but this arrangement is complicated to utilise in an IC card.

EP-A-0 297 991 discloses an IC card which is covered with resin on one side only and which, therefore, suffers from many of the above problems.

EP-A-0 277 854 discloses and IC card in which the circuit board is encapsulated, however the card must be manufactured by a suction technique similar to that described above. As a result, it is not easy to secure the circuit board in the mould during manufacture.

### SUMMARY OF THE INVENTION

In view of the above-described problems of the conventional IC card, an object of the present invention is to provide an IC card exhibiting advantages that the circuit board can be readily embedded in the card base, further the circuit board does not appear outside of the IC card, any warp of the card can be prevented, a reliability thereof can be improved, any limitation in terms of designing the IC card can be suspended, and the quality of appearance the IC card can be improved.

A still further object of the present invention is to provide an apparatus for and a method of manufacturing an IC card of the type described above.

According to the present invention there is provided an IC card according to Claim 1, and a method of manufacturing an IC card according to Claim 4. Preferred features of the invention are set out in Claims 2, 3, 5 and 6.

### BRIEF DESCRIPTION OF THE DRAWINGS

Fig. 1A is a plan view which illustrates a conventional IC card;
Fig. 1B is a sectional view taken along line IB-IB in Fig. 1A;
Fig. 2A is a broken side sectional view which illustrates a state where a circuit board is disposed in a lower mold;
Fig. 2B is a broken side sectional view which illustrates a state where an upper mold is secured to the lower mold shown in Fig. 2A;
Fig. 3A is plan view which illustrate an IC card according to the present invention;
Fig. 3B is a sectional view taken along line IIIB-IIIB in Fig. 3A;
Fig. 3C is a front elevational view which illustrates the IC card shown in Fig. 3A;
Fig. 4A is a broken side sectional view which illustrates a state where the circuit board is secured within the mold;
Fig. 4B is a broken front sectional view which illustrates a state where the circuit board is secured within the mold;
Fig. 5A is a broken plan view of a circuit board according to another embodiment of the present invention;
Fig. 5B is a sectional view taken along line VB-VB in Fig. 5A;
Fig. 6 is a broken front sectional view which illustrates a state where the circuit substrate shown in Fig. 5A is secured within the mold; and
Fig. 7 is a broken front sectional view which illustrates an essential portion of the IC card whose card base body has been molded by a mold.

### DESCRIPTION OF THE PREFERRED EMBODIMENT

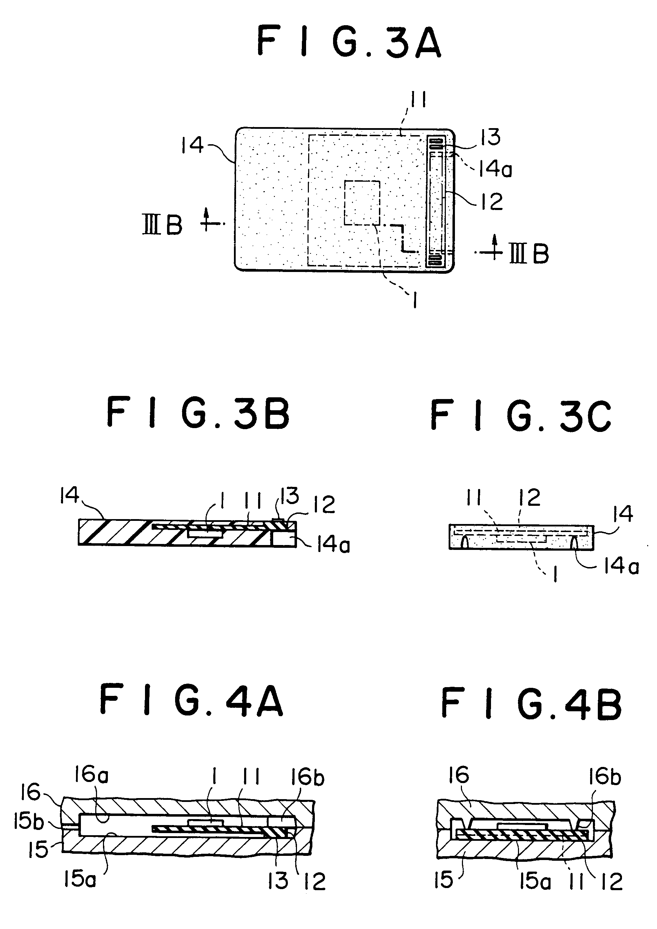

Figs. 3A to 3C are views which illustrate an embodiment of an IC card according to the present invention. Referring to the drawings, a terminal board portion 12 is integrally formed or adhered on an end portion of a circuit board 11 as to become higher than the level of the surface of the circuit board 11. On surface of the terminal substrate portion 12, a plurality of electrode terminals 13 for establishing connections with the outside of the IC card are formed, the plurality of electrode terminals 13 is connected to a circuit (not shown) which is on the reverse side of the circuit board 11. An IC 1 which is connected to the circuit is mounted on the other side, that is, a reverse side of the circuit board 11. A card base body 14 is formed by integrating and embedding the IC 1 and the circuit board 11 by means of injection-molding with synthetic resin after, wherein only the electrode terminal portion 13 of the terminal board portion 12 is allowed to appear the outside of the IC card. A pair of guide grooves 14a having a depth starting from the reverse side of the card base body 14 to the reverse surface of the terminal board portion 12 are formed at the end portions of this card base body 14, and these grooves 14a extend in the direction of insertion and withdrawal of the IC card. This pair of guide grooves 14a are formed by molding by using a mold and capable of preventing erroneous insertion of the IC card inside out into the external equipment.

The above-described card base body 14 is molded as shown in Figs. 4A and 4B. The circuit board 11 on which the IC 1 is mounted is put in the bottom portion of a recessed portion 15a of a lower mold 15 so as to allow the electrode terminal 13 to face downward. Then an upper mold 16 is secured to the lower mold 15. As a result, the terminal board portion 12 is pressed down from the reverse side by a pair of pressing projections 16b formed on the both sides of the recessed portion 16a in the upper mold 16. Consequently, the circuit board 11 is held such that the other end portion of the board 11 is floated between the two recessed portions 15a and 16a. Then, the molten synthetic resin is injected through a runner 15b into the two recessed portions 15a and 16a and the mold device is cooled down thereafter. As the result, a card base body 14 which embeds the circuit board 11 so as to allow only the portion of the electrode terminals 13 to appear on the IC card surface can be formed, and an IC card shown in Fig. 3A can be obtained. The guide grooves 14a are formed in the card base body 14 by means of the holding projections 16b of the upper mold 16.

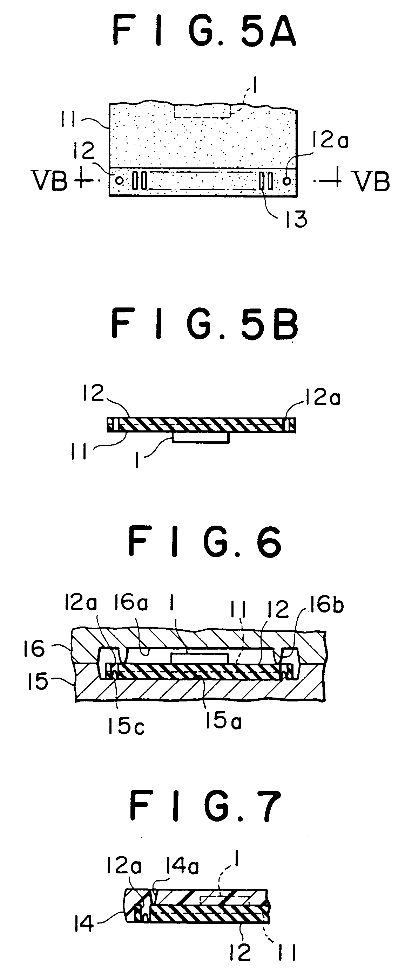

Figs. 5A and 5B are views which illustrate a circuit board portion of an IC card according to a second embodiment of the present invention. The IC 1 is mounted on the reverse side of the circuit board 11, while an injected terminal board portion 12 is integrally formed or adhered on an end portion of the obverse side of the circuit board 11. A plurality of electrode terminals 13 are formed on the terminal board portion 12, and a pair of positioning through holes 12a are formed on the both sides of the terminal board portion 12. Thus-fashioned circuit board 11, as shown in Fig. 6, is disposed within the recessed portions 15a and 16a in the upper and lower molds 15 and 16 respectively. In the mold device, the portion of the terminal board 12 is held and secured between the bottom surface of the recessed portion 15a and the holding projection 16b. A pair of positioning pin portions 15c which corresponds to the positioning holes 12a are formed on the both sides of the recessed portion 15a of the lower mold 15 as to be inserted into the positioning holes 12a to position the circuit board 11. Then the molten synthetic resin for molding is injected through a runner (see Fig. 4A) into the recessed portions 15a and 16a in the upper and lower molds 15 and 16, and the mold device is cool down thereafter. As the result, a card base body 14 can be formed so that an IC card can be manufactured, this card base body 14 being formed such that only a portion of the terminal electrodes 13 is allowed to appear on the IC card surface and the portion including the circuit board 11 is embedded in the body 14. The positioning pin portions 15c are formed conically and arranged to be lower than the thickness of the terminal board 12 so that synthetic resin can be introduced into a portion of the positioning hole 12a. As a result, the circuit board 11 can be strongly secured to the card base body 14 by injection molding with the synthetic resin.

In the above-described embodiments, although the pair of holding projections 16b are disposed on the both sides of the upper mold 16 to form the pair of guide grooves 14a, the number of the projections, that is the number of the guide grooves, may be increased.

As described above and according to the present invention, the terminal board portion is disposed at an end portion of the circuit board to project the surface of the terminal portion over the surface of this circuit board, the electrode terminals are formed on the surface of the terminal board portion, the circuit board portion which provides the IC module on the reverse side thereof is embedded in the card base body by molding with the synthetic resin, and thereby only the electrode terminal portion is allowed to appear. Consequently, the circuit board does not appear outside of the IC card, any warp of the card can be prevented, its reliability can be improved, any limitation in terms of design of the IC card can be suspended, and the quality of appearance can be improved.

At least a pair of guide grooves are formed which has the depth starting from the reverse side of the card base body to the reverse side of the terminal board portion and extends in the insertion direction of the IC card, the guide grooves being disposed at both end portions of the card base body. These guide grooves are formed by the holding projections formed in the upper mold. Since the thus-formed holding projections press down the reverse side of the terminal board disposed on the bottom surface of the recessed portion of the lower mold, they can also be used as means for securing the circuit board portion disposed in the mold. As a result, the structure of the securing means can be simplified with respect to that of the conventional securing means, and required works for securing the circuit board portion can be conducted easily.

In addition, the structure may be so arranged that a pair of positioning holes are formed on the both sides of the terminal board portion surface of the circuit board, and positioning pins each having a length shorter than the thickness of the corresponding positioning holes are formed for the purpose introducing the synthetic resin for the card base body into a part portion of the positioning holes at the time of the injection molding by using the synthetic resin. As a result, positioning of the circuit board portion can be conducted easily and the coupling of this circuit substrate portion with the card base body can be conducted strongly.

## Claims

1. An IC card comprising:
a circuit board (11) including a terminal board portion (12) disposed at an end portion thereof on one side thereof, an IC module (1) being mounted on the other side thereof;
at least one electrode terminal (13) on the surface of said terminal board portion (12) and connected to said IC; and
a card base body (14) in which by molding by using a synthetic resin, both sides of said circuit board (11) are embedded with said electrode terminal (13) appearing on the outside of said IC card,
characterized in that the terminal board portion (12) stands proud of the surface of the said one side of the circuit board (11) and the circuit board (11) is embedded in the molded resin with only the said surface of the terminal board portion (12) remaining exposed.

2. An IC card according to claim 1 further comprising a pair of guide grooves (14a) disposed in the card body at said one end of said card base body (14), formed in the direction in which said IC card is inserted and having a depth running from the side of said card base body (14) opposite to the side of the electrode terminal (13) to the side of said terminal board portion (12) opposite to the electrode terminal (13).

3. An IC card according to claim 2, wherein at least a pair of positioning through holes (12a), running in the terminal board portion (12) from the said surface of said terminal board portion (12) on which the electrode terminal (13) is situated to the side of the terminal board portion (12) opposite to the electrode terminal (13), are formed at the said one end of said terminal board portion (12) of said circuit board (11), said resin forming said card base body (14) being introduced into a respective part portion of each of said positioning holes (12a).

4. A method of making an IC card according to Claim 1, comprising the steps of providing a circuit board (11) with a terminal board portion (12) standing proud in an end region of a first surface of the circuit board (11), mounting an IC module (1) on a surface of the circuit board (11) opposite to the first surface, placing the circuit board (11) and IC module (1) in a mold cavity; and molding an insulating resin material around the circuit board (11) and IC module (1) in the mold cavity; characterised in that, during moulding, the circuit board (11) is positioned in the mould cavity with a proud surface of the terminal board portion (12) in contact with a mold surface and the rest of the circuit board (11) and IC module (1) spaced from the walls of the mold cavity.

5. A method according to Claim 4 of manufacturing an IC card according to claim 2 wherein the mould cavity is defined by a lower mold (15) having a recessed portion (15a), and an upper mold (16) including a recessed portion (16a) and provided with at least two holding projections (16b); one holding projection 16b) being situated at each side of said recessed portion (16a) and being capable of holding said terminal board portion (12) of said circuit board (11) from the side of said terminal board portion (12) opposite to the electrical terminal (13) and serving as a mold for forming a respective one of said guide grooves (14a); said method comprising:
a step in which said circuit board (11) is placed on the base of said recessed portion (15a) of said lower mold (15) so as to locate said electrode terminal (13) thereagainst;
a step in which said upper mold (16) is secured to said lower mold (15) for the purpose of holding said circuit board (11) such that an end portion of said circuit board (11) opposite to the said one end is spaced from the bases of said two recessed portions (15,16) as a result of pressing said terminal board portion (12) with the holding projections (16b) from the side of said terminal board portion opposite to the electrical terminal (13), and for the purpose of forming the said guide grooves (14a);
a step in which molten synthetic resin is injected into a molding space formed by securing said upper mold (16) to said lower mold (15); and
a step in which said molding space is cooled down.

6. A method according to claim 5 of manufacturing an IC card according to claim 3 wherein said lower mold (15) comprises at least two positining pins (15c), each having a length shorter than said positioning holes (12a) formed in said terminal board portion (12); said method comprising inserting the pins (15c) into said positioning holes (12a), wherein the circuit board (11) is located in the moulding cavity prior to injection.

## Patentansprüche

1. IC-Karte, die folgendes aufweist:
- eine Leiterplatte (11), die einen Anschlußleistenbereich (12) aufweist, der an einem Endbereich der Leiterplatte auf ihrer einen Seite angeordnet ist, wobei ein IC-Baustein (1) auf ihrer anderen Seite angebracht ist;
- wenigstens einen Elektrodenanschluß (13) auf der Oberfläche des Anschlußleistenbereichs (12) in Verbindung mit dem IC-Modul; und
- einen Kartengrundkörper (14), in dem durch Formen unter Verwendung eines Kunstharzes beide Seiten der Leiterplatte (11) eingebettet sind, wobei der Elektrodenanschluß (13) an der Außenseite der IC-Karte erscheint,
dadurch gekennzeichnet,
daß der Anschlußleistenbereich (12) von der Oberfläche der genannten einen Seite der Leiterplatte (11) hervorsteht und die Leiterplatte (11) in das Formharz eingebettet ist, wobei nur die genannte Oberfläche des Anschlußleistenbereichs (12) freigelegt bleibt.

2. IC-Karte nach Anspruch 1,
die ferner ein Paar von Führungsnuten (14a) aufweist, die in dem Kartenkörper an dem genannten einen Ende des Kartengrundkörpers (14) angeordnet sind, die in der Richtung ausgebildet sind, in der die IC-Karte eingeführt wird, und die eine Tiefe haben, die von der Seite des Kartengrundkörpers (14), die der Seite des Elektrodenanschlusses (13) gegenüberliegt, bis zu der Seite des Anschlußleistenbereichs (12) verläuft, die dem Elektrodenanschluß (13) gegenüberliegt.

3. IC-Karte nach Anspruch 2,
wobei wenigstens ein Paar von Positionierungs-Durchgangslöchern (12a), die in dem Anschlußleistenbereich (12) von der genannten Oberfläche des Anschlußleistenbereichs (12), auf der der Elektrodenanschluß (13) liegt, bis zu der Seite des Anschlußleistenbereichs (12) verläuft, die dem Elektrodenanschluß (13) gegenüberliegt, an dem genannten einen Ende des Anschlußleistenbereichs (12) der Leiterplatte (11) ausgebildet sind, wobei das den Kartengrundkörper (14) bildende Harz in einen jeweiligen Teilbereich von jedem der Positionierungslöcher (12a) eingeleitet ist.

4. Verfahren zum Herstellen einer IC-Karte nach Anspruch 1, das die folgenden Schritte aufweist:
- Vorsehen einer Leiterplatte (11) mit einem Anschlußleistenbereich (12), der in einer Endzone einer ersten Oberfläche der Leiterplatte (11) hervorsteht,
- Anbringen eines IC-Bausteins (1) an einer Oberfläche der Leiterplatte (11), die der ersten Oberfläche gegenüberliegt,
- Einbringen der Leiterplatte (11) und des IC-Bausteins (1) in einen Formenhohlraum und
- Formen eines Isolierharzmaterials um die Leiterplatte (11) und den IC-Baustein (1) herum in dem Formenhohlraum;
dadurch gekennzeichnet,
daß während des Formens die Leiterplatte (11) in dem Formenhohlraum so positioniert wird, daß eine hervorstehende Oberfläche des Anschlußleistenbereichs (12) mit einer Formenhohlraumoberfläche in Berührung ist und der Rest der Leiterplatte (11) und des IC-Bausteins (1) von den Wandungen des Formenhohlraums beabstandet ist.

5. Verfahren nach Anspruch 4 zum Herstellen einer IC-Karte nach Anspruch 2,
wobei der Formenhohlraum gebildet wird durch ein unteres Formteil (15) mit einem ausgesparten Bereich (15a) und ein oberes Formteil (16), das einen ausgesparten Bereich (16a) aufweist und mit wenigstens zwei Haltevorsprüngen (16b) versehen ist;
wobei jeweils ein Haltevorsprung (16b) an jeder Seite des ausgesparten Bereichs (16a) liegt und fähig ist, den Anschlußleistenbereich (12) der Leiterplatte (11) von der dem Elektrodenanschluß (13) des Anschlußleistenbereichs (12) gegenüberliegenden Seite zu halten, und der als Formwerkzeug dient, um jeweils eine der Führungsnuten (14a) zu formen;
wobei das Verfahren folgendes aufweist:
- einen Schritt, in dem die Leiterplatte (11) auf der Basis des ausgesparten Bereichs (15a) des unteren Formteils (15) angeordnet wird, um den Elektrodenanschluß (13) daran anliegend festzulegen;
- einen Schritt, in dem das obere Formteil (16) an dem unteren Formteil (15) befestigt wird mit dem Zweck, die Leiterplatte (11) so zu halten, daß ein dem genannten einen Ende gegenüberliegender Endbereich der Leiterplatte (11) von den Basen der beiden ausgesparten Bereiche (15a, 16a) dadurch beabstandet wird, daß der Anschlußleistenbereich (12) durch die Haltevorsprünge (16b) von der dem Elektrodenanschluß (13) gegenüberliegenden Seite des Anschlußleistenbereichs mit Druck beaufschlagt wird, und mit dem Zweck des Formens der Führungsnuten (14a);
- einen Schritt, in dem eine Kunstharzschmelze in einen Formgebungsraum gespritzt wird, der durch Befestigen des oberen Formteils (16) an dem unteren Formteil (15) gebildet wird; und
- einen Schritt, in dem der Formgebungsraum heruntergekühlt wird.

6. Verfahren nach Anspruch 5 zum Herstellen einer IC-Karte nach Anspruch 3,
wobei das untere Formteil (15) wenigstens zwei Positionierungsstifte (15c) aufweist, die jeweils eine Länge haben, die kürzer als die in dem Anschlußleistenbereich (12) gebildeten Positionierungslöcher (12a) ist;
wobei das Verfahren das Einsetzen der Stifte (15c) in die Positionierungslöcher (12a) umfaßt, so daß die Leiterplatte (11) in dem Formteil vor dem Spritzformen festgelegt wird.

## Revendications

1. Carte à circuit intégré comprenant :
une plaque de circuit (11) comprenant une portion de plaque à bornes (12) disposée à une portion d'extrémité de celle-ci sur un côté de celle-ci, un module à circuit intégré (1) étant monté sur l'autre côté de celle-ci ;
au moins une borne d'électrode (13) sur la surface de ladite portion de plaque à bornes (12) et reliée audit circuit intégré ; et
un corps de base de carte (14) dans lequel par moulage en utilisant une résine synthétique, les deux côtés de ladite plaque de circuit (11) sont enfouis avec la borne d'électrode (13) apparaissant sur le côté externe de ladite carte à circuit intégré,
caractérisée en ce que la portion de plaque à bornes (12) se dresse en faisant saillie de la surface dudit côté de la plaque de circuit (11) et la plaque de circuit (11) est enfouie dans la résine moulée avec seulement ladite surface de la portion de plaque à bornes (12) restant exposée.

2. Carte à circuit intégré selon la revendication 1 comprenant de plus une paire de rainure de guidage (14a) disposées dans le corps de carte à l'extrémité précitée du corps de base de carte précité (14), formées dans la direction dans laquelle ladite carte à circuit intégré est insérée et ayant une profondeur s'étendant du côté dudit corps de base de carte (14) opposé au côté de la borne d'électrode (13) au côté de la portion de plaque à bornes précitée (12) opposée à la borne d'électrode (13).

3. Carte à circuit intégré selon la revendication 2, dans laquelle au moins une paire de trous traversants de positionnement (12a), s'étendant dans la portion de plaque à bornes (12) à partir de la surface précitée de la portion de plaque à bornes (12) sur laquelle la borne d'électrode (13) est située au côté de la portion de plaque à bornes (12) opposée à la borne d'électrode (13), sont formés à l'extrémité précitée de ladite portion de plaque à bornes (12) de la plaque de circuit précitée (11), la résine précitée formant le corps de base de carte précité (14) étant introduite dans une portion de partie respective de chacun desdits trous de positionnement (12a).

4. Procédé de réalisation d'une carte à circuit intégré selon la revendication 1, comprenant les étapes de fournir une plaque de circuit (11) avec une portion de plaque à bornes (12) se dressant en faisant saillie dans une région d'extrémité d'une première surface de la plaque de circuit (11), monter un module à circuit intégré (1) sur une surface de la plaque de circuit (11) opposée à la première surface, placer la plaque de circuit (11) et le module à circuit intégré (1) dans une cavité de moulage ; et mouler un matériau de résine isolant autour de la plaque de circuit (11) et du module à circuit intégré (1) dans la cavité de moulage ; caractérisé en ce que, pendant le moulage, la plaque de circuit (11) est positionnée dans la cavité de moulage avec une surface en saillie de la portion de plaque à bornes (12) en contact avec une surface de moulage et le reste de la plaque de circuit (11) et du module à circuit intégré (1) espacé des parois de la cavité de moulage.

5. Procédé selon la revendication 4 de fabrication d'une carte à circuit intégré selon la revendication 2 dans lequel la cavité de moulage est définie par un moule inférieur (15) ayant une portion évidée 15(a), et un moule supérieur (16) comprenant une portion évidée (16a) et pourvue d'au moins deux saillies de maintien (16b) ; une saillie de maintien (16b) étant située à chaque côté de ladite portion évidée (16a) et étant susceptible de maintenir ladite portion de plaque à bornes (12) de ladite plaque de circuit (11) du côté de ladite portion de plaque à bornes (12) opposée à la borne électrique (13) et servant comme moule pour former l'une respective des rainures de guidage (14a) ; ledit procédé comprenant :
une étape dans laquelle la plaque de circuit (11) est placée sur la base de la portion évidée (15a) du moule inférieur (15) afin de positionner la borne d'électrode (13) contre celle-ci ;
une étape dans laquelle le moule supérieur (16) est fixé au moule inférieur (15) dans le but de maintenir la plaque de circuit (11) de sorte qu'une portion d'extrémité de la plaque de circuit (11) opposée à l'extrémité précitée est espacée des bases des deux portions évidées (15, 16) en conséquence de la pression de la portion de plaque à bornes (12) avec les saillies de maintien (16b) du côté de la portion de plaque à bornes opposée à la borne électrique (13) et dans le but de former lesdites rainures de guidage (14a) ;
une étape dans laquelle une résine synthétique fondue est injectée dans un espace de moulage formé en fixant le moule supérieur (16) au moule inférieur (15) ; et
une étape dans laquelle ledit espace de moulage est refroidi.

6. Procédé selon la revendication 5 de fabriquer une carte à circuit intégré selon la revendication 3 dans lequel le moule inférieur précité (15) comprend au moins deux axes de positionnement (15c), chacun ayant une longueur plus courte que les trous de positionnement précités (12a) formés dans la portion de plaque à bornes précitée (12) ; ledit procédé comprenant insérer les axes (15c) dans lesdits trous de positionnement (12a), où la plaque de circuit (11) est située dans la cavité de moulage avant injection.
